# EUROPEAN PATENT APPLICATION

(11) **EP 2 192 487 A1**
(43) Veröffentlichungstag der Anmeldung: **02.06.2010**
(21) Anmeldenummer: 07872134.7
(22) Anmeldetag: 22.10.2007
(51) Int. Cl.: G06F 11/00, H04L 1/20, H03M 13/35

(54) **INFORMATIONSÜBERTRAGUNG UND INTEGRIERTES SCHUTZVERFAHREN**

(30) Priorität: 30.08.2007 RU 2007132646
(71) Anmelder: Osmolovsky, Stanislav Antonovich, Moscow 119607 (RU)
(72) Erfinder: Osmolovsky, Stanislav Antonovich, Moscow 119607 (RU)
(74) Vertreter: Jeck, Anton
(86) Internationale Anmeldenummer: PCT/RU2007/000580
(87) Internationale Veröffentlichungsnummer: WO 2009/028982

(57) **Zusammenfassung**

Die Erfindung betrifft ein Verfahren zur Übertragung und zum integrierten Schutz von Informationen. Vor dem Beginn der Übertragung werden die Bedingungen für einen Informationsaustausch und die Qualität des Kanals festgelegt. Es werden optimale Werte für die Parameter n, k und m eines benutzten stochastischen q-teiligen (n, k, q, m)-Codes auf der Basis eines (n, k) Binärcodes als Quelle mit I-Beschränkung (q = 2^{I}) und einer Übergabe der m-Blöcke des Codes mit gleichen Werten des Informationsteils ausgewählt. Die Information wird mit Hilfe des ausgewählten q-teiligen Codes kodiert. Die q-teiligen Symbole werden vor der Übergabe in den Kanal direkt randomisiert. Die q-teiligen Symbole werden beim Empfang der Information zurück randomisiert. Es werden die Integrität und Authentifizierung der q-teiligen Symbole und Nachrichten sowie die Gültigkeit der vollständigen Symbole geprüft. Die Integrität wird in den m-Codeblöcken wiederhergestellt. Die gültigen q-teiligen Symbole werden nach der Verarbeitung der m-Codeblöcke für die Ausgabe an einen Verbraucher gespeichert. Es wird geprüft, ob die Werte der Parameter n, k und m optimal sind und es werden die Werte der Parameter n, k und m korrigiert.

## Beschreibung

Die Erfindung betrifft ein Verfahren zur Übertragung und zum integrierten Schutz von Informationen.

Die Erfindung zeigt technische Mittel für eine störungssichere Übertragung über Kommunikationskanäle und Netzwerke und für einen integrierten Schutz der Information gegen unterschiedliche Einwirkungen auf die Information bei der Übertragung und der Speicherung. Die Erfindung kann in Datensystemen, in Funknetzen und in Kommunikationskanälen unterschiedlicher Art eingesetzt werden.

Bekannt sind Verfahren zur Übertragung von Informationen über Kommunikationskanäle, in welchen störungssichere zyklische Codes verwendet werden. Diese Codes ermitteln Fehler in Protokollen des Datenübertragungskanals. In den Protokollen wird die übertragene Information, die in Form von Blöcken des zyklischen Codes empfangen und auf Verzerrungen überprüft wird, mit Hilfe des zyklischen Codes kodiert. Die verzerrten Blöcke werden wiederholt als Rücknachricht übertragen [1].

Diese Verfahren haben folgende Hauptnachteile:
- Wenn die Qualität des diskreten Übertragungskanals verschlechtert wird, ist die Übertragung der Daten unmöglich, weil ein großer Anteil an Blöcken verzerrt ist und der Datenübertragungskanal "endlos arbeitet".
- Das Verfahren zur Erkennung der Fehler mit Hilfe der zyklischen Codes stellt eine effiziente Übertragungsgeschwindigkeit, die sich an die Übertragungskapazität annähert, nicht sicher.

Bekannt sind Verfahren zur Informationsübertragung mit Hilfe von algebraischen Codes mit einer Fehlerkorrektur (Hamming-Code, Bose-Chaudhuri-Hocquenghem-Codes, Reed-Solomon-Codes und andere) [2].

Diese Verfahren haben folgende Nachteile:
- Die algebraischen Codes im Korrekturmodus sind für Fehler sehr anfällig. Dies führt zu einer großen und nicht regelbaren Wahrscheinlichkeit eines Fehlers beim Dekodieren in Kanälen mit verdichteten Fehlern, was in realen Kommunikationskanälen passiert;
- die Kodierung und besonders die Dekodierung der bekannten Codes werden relativ schwer realisiert, besonders bei einer Softwarerealisierung.

Aus [2, 3] sind Verfahren zur Verschlüsselung der Information bekannt, die auf der Verwendung einer kryptographischen Umwandlung der Information basieren, sowie ein Verfahren zum integrierten Schutz der Information mit Hilfe der kryptographischen Umwandlung und einer störungsfreien Kodierung. Dabei werden im Verfahren einzelne Schutzverfahren auf der Basis unterschiedlicher Verfahren der Informationsbearbeitung kombiniert, beispielsweise ein störungsfreier zyklischer Code mit einer Fehlererkennung, einer kryptographischen Transformation der Information, einem Message Authentication Code zur Prüfung der Integrität der Information usw.

Diese Verfahren haben folgende Nachteile:
- keine Integrität bei der Bearbeitung der Information, was ihrerseits:

- die Redundanz an Information erhöht, die für den integrierten Schutz der Information eingegeben wird;
- die Bearbeitung komplizierter macht und die Geschwindigkeit beim Informationsaustausch reduziert;
- die Wiederherstellung der Integrität und die Korrektur der normalen Fehler im Kommunikationskanal werden nicht sichergestellt;
- der Schutz vor dem Aufdrängen einer falschen Information bei einer direkten Korrektur der Fehler wird mit Hilfe der Codes nicht sichergestellt.

Aus [3, 4] sind Verfahren zur Abgrenzung des Benutzerzugangs zur Information bekannt. Sie beruhen entweder auf der Verwendung eines Passwortsystems oder auf der Verschlüsselung der Information, die auf den Datenträgern der Rechner gespeichert wird. Der Schutz auf der Basis von Passwörtern ist nicht widerstandsfähig genug, weil die Information auf dem Speicher des Rechners nicht umgewandelt wird und das System zur Überprüfung des Passwortes durch einen erfahrenen Programmierer überwunden werden kann. Der Schutz auf der Basis einer Verschlüsselung der Information im Speicher des Rechners stellt hohe Anforderungen an die Geschwindigkeit der Bearbeitung der Information beim Ein- und Ablesen der Information. Deshalb wird dieser Schutz relativ selten verwendet. Er ist auf Grund der niedrigen Transformationsgeschwindigkeit eingeschränkt, die eine Informationsverarbeitung verzögert. Für eine breite Verwendung einer Datenverschlüsselung ist ein Kryptoalgorithmus mit einer hohen Geschwindigkeit der Bearbeitung und mit einem großen Schlüsselraum notwendig.

Es ist ein Verfahren zur Kontrolle der Integrität der Information, zur Authentifizierung der Benutzer und der Nachrichten auf der Basis einer elektronischen, digitalen Signatur und eines Systems der öffentlichen Schlüssel [3] oder eines Authentifizierungscodes bzw. eines Codes mit einer Sicherheit gegen Simulieren bekannt. Bekannt ist jedoch auch, dass eine solche Lösung nicht "theoretisch sicher" ist. Es wurde eine Abhängigkeit zwischen der Sicherheit des Systems zum Schutz der Integrität der Information festgestellt, d. h. die Wahrscheinlichkeit einer Nichtermittlung der Auswechslung hängt von der Anzahl der verwendeten Schlüssel ab.

Diese bekannten Verfahren haben folgende Nachteile:
- Komplizierte und langsame Realisierung, die die Verwendung in der Realzeit stört;
- Fehlen einer genauen Einschätzung für die Wahrscheinlichkeit des Aufdrängens einer falschen Information ("Verfälschung" der Signatur), weil die Länge der Steuerreihenfolge (Schlüssel) wesentlich kürzer als die Länge der geschützten Nachricht ist;
- Schwierigkeiten bei der Realisierung eines integrierten Informationsschutzes auf der Basis der Mittel für digitale Signaturen.

Es sind folgende Einwirkungen auf die Information in Informations- und Kommunikationssystemen, darunter auch absichtlich destruktive Einwirkungen, bekannt:
- Versuch einer Kommunikationsunterdrückung dadurch, dass intensive künstliche Störungen erzeugt werden, die durch die verwendeten Schutzverfahren gegen Störungen nicht beseitigt werden können;
- Versuch einer Zerstörung der Datenbanken im Informationssystem;
- Versuch, vertrauliche Information aus dem System abzufragen;
- Versuch, falsche Information aufzudrängen.

In aktuellen internationalen Standards für Funksysteme sieht man eine Tendenz zur Verwendung einer Gesamtheit von Funktionen vor, die dem Schutz der Information zugeordnet werden können, um in der Hard- und Software des Systems zu funktionieren:
- Fehlerschutz in Kommunikationskanälen mit Hilfe von störungssicheren Codes;
- Authentifizierung der Nachrichten und eine Kontrolle der Integrität der Information (Schutz gegen das Aufdrängen einer Information);
- Zufallsauswahlverfahren der Signale;
- Schutz gegen Einblick in die Information (Kryptoschutz).

Als Beispiel können der Standard IEEE 802.16 (WiMax) und der europäische Standard EN 300 (DVB) angeführt werden. Dabei werden unterschiedliche Verfahren (Algorithmen, Software, Geräte) für einzelne Aufgaben des Schutzes verwendet, was eine Realisierung komplizierter macht, Schwierigkeiten bei dem Wechsel der Parameter jedes einzelnen Verfahrens hervorruft und die Effizienz des Schutzes reduziert, aber auch zur allgemeinen Redundanz der Information führt.

Es ist Aufgabe der Erfindung, eine vielseitige Anwendbarkeit eines Verfahrens zur Übertragung und zum Schutz der Information im Rahmen der Gesamtheit von Funktionen dieses Verfahrens zu schaffen, sowie die Übertragungsmöglichkeiten durch alle beliebigen Kommunikationskanäle und die Sicherstellung der garantierten Parameter (Wahrscheinlichkeits- und Zeitparameter) sowie die Herstellung einer universellen Hardware für eine breite Arten- und Qualitätspalette der Kommunikationskanäle zu gewährleisten. Die Hardware soll an die Anwendungsbedingungen und die erreichten Möglichkeiten angepasst werden können.

Die gestellte Aufgabe wird durch die Merkmale des Anspruchs 1 gelöst.

Das vorgeschlagene Verfahren ermöglicht es, im Rahmen eines Funktionssatzes zur Verarbeitung der Information bei einer einmaligen Eingabe einer Redundanz alle oben genannten Funktionen zum Informationsschutz mit einer höheren Effizienz auszuführen.

Im Rahmen des integrierten Schutzes gemäß dem Verfahren werden folgende Aufgaben gelöst:
- Schutz gegen Verzerrungen in den Kommunikationskanälen (Netzen);
- Kryptographischer Schutz gegen einen Einblick;
- Kryptographischer Schutz gegen ein Aufdrängen einer falschen Information;
- Kontrolle und Wiederherstellung der Integrität der Information;
- Abgrenzung des Zugangs zur Information durch die Benutzer;
- Schutz gegen absichtliche destruktive Einwirkungen auf die Information in den Informationssystemen.

Um das gestellte Ziel zu erreichen, werden drei Ideen verwendet:
- Verwendung einer zufälligen Transformation, die den Zufall in den Prozess einbringt. Das führt den Übertragungsprozess zur Verwendung aller möglichen Signale oder des Codes- und Schlüsselsystems (spielerische Herangehensweise, die den Sieg des "Gegners" minimiert) zurück;
- Verwendung des Prinzips und der Dekodierungsfunktionen von mehreren Kopien des Codeblocks, um die Sicherheit der Aufschlüsselung zu erhöhen und eine hohe Informationsgültigkeit der aufgeschlüsselten Information sicherzustellen;
- Verwendung der Mittel zur Prüfung der Gültigkeit der Entscheidungsfunktion bei der Erkennung der richtig aufgenommenen Symbole, die bei der Entschlüsselung das Erreichen jeder beliebigen Wahrscheinlichkeit eines Entschlüsselungsfehlers, der konstruktiv angegeben ist, durch eine Prüfung des genau berechneten Verschlüsselungsergebnisses sicherstellen.

Um das Ziel der Erfindung zu erreichen, werden stochastische (n, k, q, m)-Codes verwendet. Hier sind n und k Parameter des ursprünglichen Binärcodes, q die Codebasis und m die Anzahl der Wiederholungen des Codeblocks mit einem gleichen Informationsteil (Kopie der Codeblöcke). Die stochastischen Codes führen auf die Verwendung der Gesamtheit von Codes und Schlüsseln zurück, die eine garantierte Gültigkeit bei einer Markierung der nicht verzerrten Symbole (Lokalisierung) sicherstellen. Zudem wird eine Komplikation der Bearbeitung bei einer genauen Berechnung der Ergebniswahrscheinlichkeit und der Deckung des ganzen Bereichs der Kanalqualität als Duplex und Simplex erreicht, um optimale Ergebnisse zu erzielen.

Dabei wird die Aufgabe gestellt, jede Art des Schutzes im Vergleich zu den bekannten Schutzmitteln effizienter zu realisieren. Die Schutzmittel sollen eine neue Qualität bei garantierten Parametern des Informationssystems aufweisen. Darunter fallen eine garantierte hohe Gültigkeit bei einem gestreuten Charakter der Verzerrungen (die Fehlerwahrscheinlichkeit in der Information, die der Benutzer bekommt, soll 10⁻⁹, 10⁻¹⁸ und weniger sein), eine garantierte Übertragung der Nachrichten durch jeden Kanal mit einer Übertragungskapazität über Null durch Verwendung der Anpassung an die Kanaleigenschaften, die mit Hilfe der Wahrscheinlichkeit der Verzerrung des q-teiligen Symbols beschrieben werden, eine garantierte Stabilität des Schutzes und andere Eigenschaften.

Gemäß der Erfindung wird das Verfahren zur Übertragung und zum integrierten Schutz der Informationen in folgender Weise ausgeführt:

Das Verfahren zur Übertragung und zum integrierten Schutz der Information besteht in Folgendem:

Vor dem Beginn der Übertragung werden die Bedingungen für einen Informationsaustausch und die Qualität des Kanals festgelegt. Es werden optimale Werte für die Parameter n, k und m des benutzten stochastischen q-teiligen (n, k, q, m)-Codes auf der Basis des (n, k) Binärcodes als Quelle mit *I*-Verschränkung (q=2^{I}) und der Übergabe der m-Blöcke des Codes mit den gleichen Werten des Informationsteils ausgewählt. Die Information wird mit Hilfe des ausgewählten q-teiligen Codes kodiert. Vor der Übergabe in den Kanal werden die q-teiligen Symbole direkt randomisiert. Beim Empfang der Information werden die q-teiligen Symbole zurück randomisiert. Es werden die Integrität und die Authentifizierung der q-teiligen Symbole und Nachrichten sowie die Gültigkeit der vollständigen Symbole geprüft. Die Integrität in den m-Codeblöcken wird wiederhergestellt. Nach der Verarbeitung der m-Codeblöcke werden die gültigen q-teiligen Symbole für die Ausgabe zum Verbraucher gespeichert. Es wird geprüft, ob die Werte der Parameter n, k und m optimal sind. Gegebenenfalls werden die Werte korrigiert.

Dabei werden die einzelnen Aufgaben der Informationsübertragung und des Informationsschutzes im Rahmen eines einheitlichen Verfahrens auf folgende Weise gelöst:

Die Übertragung der Information erfolgt über alle Kanaltypen mit einer Übertragungskapazität über Null. Dabei werden alle kontrollierten, vorher festgelegten Eigenschaften des Protokolls zur Informationsübertragung sichergestellt.

Der integrierte Informationsschutz wird als Schutz gegen Verzerrungen in den Kommunikationskanälen, den Funknetzen und den Informationsspeichern als Gültigkeitsprüfung und Wiederherstellung der Integrität der Information, als Abgrenzung des Zugangs zur Information durch die Benutzer, als kryptographischer Schutz gegen den Einblick, als kryptographischer Schutz gegen das Aufdrängen einer falschen Information, als Schutz gegen absichtliche destruktive Einwirkungen auf die Information in Informationssystemen und als Sicherstellung der garantierten Informationseigenschaften des Systems ausgeführt.

Die Qualität des verwendeten Kommunikationskanals oder des Speichermediums für die Information wird mittels der Übergabe des Blocks des stochastischen q-teiligen Wiederholungscodes (n, I, q) analysiert. Danach werden die empfangenen q-teiligen Symbole symbolweise verglichen und die Anzahl der übereinstimmenden q-teiligen Symbole berechnet. Es wird der Anteil der übereinstimmenden Symbole in Bezug auf die Länge des n-Codes berechnet. Nach dem berechneten Wert des Anteils von unverzerrten q-teiligen Symbolen werden die Parameter des Codes für die Wiederherstellung der Integrität für die Übertragung der Information durch diesen Kanal ausgewählt.

Die optimalen Parameter des Codes für Duplexkanäle für eine öffentliche Nutzung werden nach dem Kriterium "maximale Übertragungsgeschwindigkeit" ausgewählt, wobei die vorher bestimmte Gültigkeit sichergestellt werden soll. Die bestimmte Gültigkeit wird anhand der Wahrscheinlichkeit eines Fehlers in der Information eingeschätzt, die an den Informationsempfänger geliefert wird.

Die optimalen Parameter des Codes für Simplexkanäle werden nach dem Kriterium Sicherstellung der notwendigen Sicherheit bei der Lieferung einer Nachricht ausgewählt. Diese Sicherheit wird anhand der Wahrscheinlichkeit der Lieferung einer Nachricht nach der ersten Übertragung eingeschätzt, wobei die notwendige Gültigkeit sichergestellt werden soll.

Die q-teiligen Signalsymbole werden bei der Übertragung für die Transformation der Symbolwerte in ein zufälliges Signal unabhängig von der übertragenen Information randomisiert. Beim Empfang werden die q-teiligen Symbole für die Transformation des Fehlervektors des q-teiligen Symbols mit der gleichen Wahrscheinlichkeit in einen der q-1 Werte des q-teiligen Symbols, außer dem übertragenen Symbol, randomisiert.

Die Randomisierung der q-teiligen Symbole wird nach einem Verfahren ausgeführt, das durch die doppelt-stochastische Übergangsmatritze beschrieben wird. In diesem Verfahren wird ein Randomisierungsparameter verwendet, der von der Quelle unabhängig von der übertragenen Information empfangen wird.

Für die Synchronisierung der Prozesse zur Erzeugung der Randomisierungsparameter in den Übertragungs- und Empfangsteilen werden unveränderte Ausgangswerte des Zustands von Synchronzufallsgeneratoren oder eines kryptographischen Systems von geheimen oder öffentlichen Schlüsseln verwendet.

Die Kontrolle der Integrität der empfangenen q-teiligen Symbole des (n, k, q)-Codes wird mit Hilfe von N = 2^{n-k} - 1 Prüfverhältnissen des Codes ausgeführt, die die Zeilen einer Prüfmatrize des Binärcodes H und deren Linearkombinationen sind. Für ein j-ges Verhältnis erfolgt die Kontrolle der Integrität durch Addieren nach dem Modul 2 von n q-teiligen Symbolen, wobei das Symbol 1 in diesem j-gen Prüfverhältnis der Prüfung des Werts der berechneten Summe entspricht. Dabei gilt das Verhältnis als erfüllt und die q-teiligen Symbole werden vorläufig als vollständig und lokalisiert anerkannt, wenn diese Summe der Kombination aus I Nullbinärsymbolen gleich ist. Es werden die Anzahl der lokalisierten Symbole (N_{L} ⊂ [0, n]) sowie die Anzahl der erfüllten Verhältnisse N_{c} (N_{c} ⊂ [0,2^{n-k} - 1]) berechnet. Für jedes q-teilige Symbol mit der Nummer i wird die Anzahl der erfüllten Verhältnisse berechnet, in dem dieses Symbol Mᵢ enthalten war.

Die Kontrolle der Gültigkeit der Integrität für die Codeblöcke wird durch Prüfung der Bedingungen Nᵥ = 2^{r-t*} , t* ≤ d-2 ausgeführt, wobei t* = n - N_{L} und d der Codeabstand des binären (n, k) Codes ist.

Die Kontrolle der Gültigkeit der Integrität einzelner q-teiliger Symbole wird durch die Prüfung der Bedingungen *Mᵢ*(*t**) ≥ Π*_{q}*(*t**) ausgeführt, wobei Π_{q} (t *) die Schwellenwerte der Anzahl der ausgeführten Verhältnisse für ein q-teiliges Symbol mit einem bestimmten Wert t* sind.

Die Symbole, für die die Bedingung nicht erfüllt wird, werden gelöscht, und der Wert N_{L} wird um die Anzahl der gelöschten Symbole reduziert.

Die Wiederherstellung der Integrität der Information wird durch eine Korrektur der nicht lokalisierten und gelöschten Symbole durchgeführt. Der Wert des korrigierten Symbols wird durch die Werte der gültigen lokalisierten oder vorher korrigierten Symbole dargestellt. Dafür wird ein Prüfverhältnis ausgewählt, zu welchem ein zu korrigierendes Symbol und andere gültig lokalisierte oder vorher korrigierte Symbole gehören. Der Wert des korrigierten Symbols wird durch Addieren nach dem Modul von 2 Werten der gültigen lokalisierten und vorher korrigierten Symbole berechnet, die zu dem ausgewählten Prüfverhältnis gehören.

Die Dekodierung der m-Kopien des (n, k, q)-Codes wird durch eine Lokalisierung und eine Erfassung der richtig empfangenen Symbole in drei Schritten ausgeführt. Dabei werden die Gesamtzahl der erfüllten Verhältnisse und die Anzahl der erfüllten Verhältnisse für jedes Symbol berechnet. Dafür werden die m gleichnamigen Symbole wie für den Block des q-teiligen (m, I, q)-Codes paarweise verglichen. Die übereinstimmenden Symbole werden als lokalisierte Symbole gespeichert. Die richtig empfangenen Symbole für jeden der m-Blöcke werden nach den Dekodierungsregeln des (n, k, q)-Codes lokalisiert. Die Symbole, die in jedem beliebigen Block lokalisiert wurden, werden gespeichert. Die vorher nicht lokalisierten Symbole werden durch Substitution der Werte von nicht lokalisierten q-teiligen Symbolen aus unterschiedlichen Kopien in das zu prüfende Prüfverhältnis querlokalisiert. Nach der Lokalisierung wird diese auf Richtigkeit geprüft. Unsichere und nicht lokalisierte Symbole werden dadurch korrigiert, dass ihre Werte durch die Werte richtig lokalisierter Symbole dargestellt werden.

Zur Kontrolle der Optimalität des eingesetzten Codes wird die Anzahl der Blöcke Nₒₜ berechnet, bei denen die Integrität mit einer notwendigen Gültigkeit des Kanals auf einer Länge G zuletzt empfangener Blöcke durch den eingesetzten Code nicht wiederhergestellt wurde. Nach dem Empfang des nächsten Blocks mit der nicht hergestellten Integrität wird der Anteil solcher Blöcke aus α = N_{OT} / G berechnet. Die Optimalitätsbedingungen für die eingesetzten Codes werden in Form des Verhältnisses βₘᵢₙ ≤ α ≤ βₘₐₓ geprüft. Wenn βₘᵢₙ ≥ α, wird eine Entscheidung getroffen, ob der eingesetzte Code durch einen störanfälligeren Code ersetzt wird. Wenn α ≥ βₘₐₓ, wird eine Entscheidung getroffen, ob der eingesetzte Code durch einen weniger störanfälligen Code ersetzt wird.

Die allgemeine Anwendbarkeit für alle Kanäle mit einer Übertragungskapazität über Null wird auf folgende Weise erreicht:

Die Verwendung beliebiger Duplexkanäle mit einer Übertragungskapazität über Null wird durch die Kontrolle der Gültigkeit jedes Blocks und durch eine adaptive Auswahl des (n, k, q)-Codes bei m = 1 erreicht, der für den jetzigen Zustand des Kanals optimal ist.

Die Verwendung beliebiger Simplexkanäle mit einer Übertragungskapazität über Null wird durch die Kontrolle der Gültigkeit jedes Codeblocks und eines q-teiligen Symbols und durch eine m-fache Übertragung der Codeblöcke mit einer mitlaufenden Dekodierung der m-Kopien der Codeblöcke erreicht. Dabei wird m abhängig von der notwendigen Wahrscheinlichkeit der Lieferung der Nachricht nach der ersten Übertragung durch den eingesetzten Kanal mit Hilfe von ausgewählten (n, k, q)-Codes festgelegt. Das kann bei einer Übertragung η-fach durch jeden der X parallelen Kanäle erfolgen (m = Xη).

Dabei werden die einzelnen Aufgaben des integrierten Informationsschutzes auf folgende Weise ausgeführt:

Der Schutz gegen Verzerrungen in Kanälen und Funknetzen sowie in Informationsspeichern wird durch eine direkte Wiederherstellung der Integrität mittels eines Codes so ausgeführt, dass eine garantierte Gültigkeit in einem beliebigen Kanal bei einer maximal möglichen Geschwindigkeit in Duplexkanälen bestimmter Qualität und eine notwendige Zuverlässigkeit der Lieferung der Nachricht in Simplexkanälen erreicht wird. Dabei wird die Integrität der Information in Rahmen der Korrekturfähigkeit des (n, k, q)-Codes wiederhergestellt. Die Fehler werden mit einem Vielfachen erkannt, die die Korrekturfähigkeit des Codes übertrifft. Die Codeblöcke werden wiederholt mit den nicht korrigierten Verzerrungen übertragen. Sie werden nach einem festgelegten Kriterium der Optimalität der Parameter und der Korrigierfähigkeit des Codes angepasst.

Die Kontrolle der Echtheit und die Wiederherstellung der Informationsintegrität werden mit Hilfe der authentifizierten stochastischen q-teiligen (n, k, q, m)-Codes mit Randomisierungseigenschaften erreicht. Die Randomisierungseigenschaften werden von der Quelle mit einer Anfangsausfüllung empfangen, die als Authentifizierungsschlüssel verwendet wird.

Zur Abgrenzung des Zugangs der Benutzer zur Information bei der Speicherung und der Übergabe der Nachrichten eines bestimmten Benutzers wird eine Randomisierung (stochastische Transformation) der Nachricht (der Daten) durchgeführt. Dabei wird eine Randomisierungseigenschaft verwendet, die im individuellen Schlüssel des entsprechenden Benutzers erstellt wird.

Beim kryptographischen Schutz gegen einen Einblick wird eine Randomisierung der q-teiligen Symbole des Codes durch ein Schlüsselsystem unabhängig vom eingesetzten störungssicheren Code durchgeführt. Das Schlüsselsystem wird in jedem Verschlüsselungsblock geändert. Dabei stellt eine direkte Randomisierung (verschlüsselte stochastische Transformation) des q-teiligen Symbols einen quasi zufälligen Charakter des Signals unabhängig von der Art der übertragenen Information sicher. Dabei wird auch eine gleiche Wahrscheinlichkeit für jeden von q-1 möglichen Werten des Symbols, ausschließlich des übertragenen Symbols, sichergestellt.

Der Schutz gegen ein Aufdrängen einer falschen Information in einem Kanal mit absichtlichen Störungen erfolgt mit Hilfe eines (n, k, q)-Codes für die Wiederherstellung der Integrität bei einer garantierten Wahrscheinlichkeit des Aufdrängens der falschen Information, die nicht höher als q-1 ist. Die Codeblöcke mit nicht wiederhergestellten Verzerrungen werden wiederholt nach einer Rücknachricht übertragen.

Für den Schutz gegen absichtliche destruktive Einwirkungen auf die Informationssysteme in Form von absichtlichen Störungen in den Kommunikationskanälen und der Eingabe von falschen, destruktiven Informationen wird ein stabiler Informationsaustausch mit Hilfe einer Adaptation zum Zustand des Kanals unter anderem bei einer wesentlichen Reduzierung der Kanalqualität sichergestellt.

Die garantierten Charakteristika der Informationssysteme unter beliebigen Funktionsbedingungen werden durch eine Verwendung der Code- und Schlüsselsysteme erreicht. Die Systeme für jeden Codeblock und das q-teilige Symbol ändern sich entsprechend. Dabei wird die Übertragung der Signale aus allen möglichen 2ⁿ auf binärer Reihenfolge der Länge n im Kommunikationskanal sichergestellt, und zwar als ein Ergebnis des Strategiewechsels bei der Bekämpfung der Quelle der destruktiven Einwirkungen auf das Informationssystem.

### Die wichtigsten Eigenschaften des Verfahrens sind die Folgenden:

Die garantierte, zufällig festgelegte Wahrscheinlichkeit eines Dekodierungsfehlers Pₑᵣ bei der Dekodierung der einzelnen Blöcke (m = 1) und m Kopien im Block des (n, k, q, m)-Codes wird durch eine Korrektur der Fehler bis zu einem bestimmten t-Vielfachen, das den Wert dm -1 - (log₂ Pₑᵣ)/I (t ≤ dm-1 - (log₂ Pₑᵣ)/I) nicht übertrifft, erreicht. Bei einem Fehlervielfachen, das diesen Wert übertrifft, wird die Information an den Verbraucher nicht geliefert oder mit einem Kommentar über die Nichterfüllung der Anforderungen zur Gültigkeit geliefert.

Es werden mehrere Gültigkeitsstufen bei einer Basis des q-Codes und einem Code-abstand des d-Binärcodes mittels einer Filterung auf der Empfangsseite der dekodierten Blöcke sichergestellt. Bei einer Anzahl der korrigierten Fehler von t = d-2 in diesem Block beträgt der Dekodierungsfehler q⁻¹, bei einer Anzahl der korrigierten Fehler von t = d-3 beträgt der Dekodierungsfehler q⁻² und bei einer Anzahl der korrigierten Fehler von t = d-4 beträgt der Dekodierungsfehler q⁻³.

Eine garantierte Lieferung der Nachricht mit einer geforderten Wahrscheinlichkeit oder einem Austausch in der Echtzeit wird durch die Übertragung der m Blöcke mit dem gleichen Informationsteil und der Wiederherstellung der Integrität im Modus der Dekodierung von Kopien erreicht. Dabei wird die Anzahl der Kopien m in Abhängigkeit von der notwendigen Wahrscheinlichkeit der Lieferung der Nachrichten nach der ersten Übertragung P_{lief} = P(≤ t, N_{nachr}) berechnet, wobei t die Anzahl der korrigierten verzerrten q-teiligen Symbole auf der Länge der Nachricht N_{nachr} ist, die in der Anzahl der q-teiligen Symbole dargestellt wird.

### Das Verfahren wird in folgender Reihenfolge ausgeführt:

Vor dem Beginn der Informationsübertragung durch einen Kommunikationskanal, dessen Eigenschaften nicht bekannt sind, wird der Kanal geprüft. Alle Schritte des Verfahrens werden für jeden beliebigen Kanal mit einer Übertragungskapazität über Null gleich ausgeführt. Eine Prüfreihenfolge in Form eines stochastischen (n, I)-Codes wird über den Kanal übertragen. Dabei wird der Wert n folgenderweise ausgewählt: je größer der Adaptationsbereich (Verhältnis zwischen dem schlechtesten und dem besten Zustand des Kanals), beispielsweise n = 100, desto größer ist der Wert n. Jedes der n q-teiligen Symbole des Codes wird bei der Übertragung direkt und beim Empfang zurück randomisiert (stochastisch umgewandelt). Das minimiert die Wahrscheinlichkeit einer zufälligen Übereinstimmung von 2 (3 oder mehreren) verzerrten Symbolen Es muss betont werden, dass bei n = 100 die Prüfung als erfolgreich gilt, wenn aus 100 Symbolen 2 oder mehrere q-teilige Symbole unverzerrt bleiben. Wenn der Zustand des Kanals sehr schlecht ist, dann kann für die Übertragung der nützlichen Information auch ein Wiederholungscode verwendet werden, der eine Lieferung der Nachricht (eines Teils der Nachricht) mit einer Länge von I Bit (ein q-teiliges Symbol) mit einer Verzerrung von n-2 aus n Symbolen des Codes mit der Wiederholung sicherstellen kann. Für einen sehr guten Kanal, beispielsweise mit einer Wahrscheinlichkeit der Verzerrung des binären Symbols Pₒ = 10⁻⁵ (Wahrscheinlichkeit der Verzerrung eines q-teiligen Symbols der Größenordnung von 10⁻³) ist ein Code mit den Eigenschaften von Hamming-Code mit einer zusätzlichen Prüfung auf Parität mit einem Code-Abstand von d = 4 optimal, der t = 2 verzerrte q-teilige Symbole korrigiert, zum Beispiel mit den Eigenschaften (512,502) und einer Codegeschwindigkeit von 502/512 = 0,9804. Dabei sind die binären Eigenschaften des Codes gleich (512I, 502I).

Die zu schützende Information wird auf q-teilige Symbole mit einer Länge von I Bit (q=2^{I}) aufgeteilt. Der Wert der Länge dieses Symbols wird ausgehend von der notwendigen Gültigkeit ausgewählt. Die Gültigkeit wird durch die Wahrscheinlichkeit eines Dekodierungsfehlers P_{fe} beschrieben. Bei dem ausgewählten q gilt ein Verhältnis P_{fe} ≤ q⁻¹ beispielsweise für die Sicherstellung P_{fe} = 10⁻⁹, und es kann der Wert I = 32 Bit verwendet werden. Wichtig ist, dass nach diesem Verfahren eine beliebige Gültigkeit erreicht werden kann. Die Gültigkeit wird konstruktiv bei der Projektierung festgelegt. In einem zufälligen Kommunikationskanal ist die Gültigkeit sichergestellt. So wird bei I = 64 ein P_{fe} ≤ q⁻¹ = 10⁻¹⁸ sichergestellt usw.

Für alle k q-teiligen Symbole werden n-k redundante q-teilige Symbole gemäß der Regel des binären (n, k)-Codes gebildet. Vor der Übergabe in den Kommunikationskanal wird jedes q-teilige Symbol randomisiert. Dabei wird eine Randomisierungseigenschaft ξ mit einer Länge I von einem unabhängigen Sensor verwendet. Auf der Empfangsseite wird jedes q-teiliges Symbol stochastisch mit Hilfe von synchron erstellten Werten ξ mit einer Länge I zurück transformiert. Die richtig empfangenen lokalisierten q-teiligen Symbole werden lokalisiert. Die falsch lokalisierten Symbole werden gelöscht. Nicht lokalisierte und gelöschte Symbole werden korrigiert. Dabei werden die Werte der korrigierten Symbole durch die Werte der richtig lokalisierten Symbole dargestellt.

Dabei werden die über redundante Symbole abwechselnd für die i-ten q-teiligen Symbole (i ⊂ [1, n-k]) dadurch gebildet, dass die q-teiligen Informationssymbole nach dem Modul 2 addiert werden. Den q-teiligen Informationssymbolen entspricht das Symbol 1 in der i-ten Zeile der Prüfmatrize H des binären (n, k)-Codes.

Auf der Senderseite (vor dem Speichern) wird die Kombination der Randomisierungseigenschaften mit einer Länge von I Bit von einer unabhängigen Informationsquelle für jedes q-teilige Symbol erarbeitet. Dann wird jedes q-teilige Symbol mit Hilfe der Randomisierungseigenschaft randomisiert.

Auf der Empfängerseite wird die Kombination der Randomisierungseigenschaft mit einer Länge von I Bit für jedes q-teilige Symbol nach dem Empfang vom Kommunikationskanal oder nach dem Ablesen aus dem Speicher erarbeitet. Synchron mit der Senderseite wird jedes q-teilige Symbol mit Hilfe der Randomisierungseigenschaft zurück randomisiert.

Danach wird die Integrität der q-teiligen Symbole durch die Markierung (Lokalisierung) der richtig empfangenen Symbole geprüft. Um die garantierte Gültigkeit in einem beliebigen Kanal zu gewährleisten, wird das Prinzip einer mehrfachen Fehlererkennung unter den Symbolen des Codeblocks verwendet. Wenn die Gesamtheit der unverzerrten Symbole, die zu einem Prüfverhältnis des Codes gehören, erfüllt wird, gelten die unverzerrten q-teiligen Symbole, die zu diesem Verhältnis gehören, als erkannt oder lokalisiert. Die richtig empfangenen q-teiligen Symbole werden mit Hilfe von N = 2^{n-k} - 1 Prüfverhältnissen des Codes lokalisiert, die die Zeilen der Prüfmatrize des Binärcodes H und deren Linearkombinationen sind. Die Kontrolle der Richtigkeit des Empfangs der q-teiligen Symbole für ein i-tes Verhältnis erfolgt durch ein Addieren mit dem Modul 2 von n q-teiligen Symbolen. Dabei entspricht das Symbol I diesem Prüfverhältnis, sowie durch die Prüfung dem Wert der berechneten Summe. Dabei gilt das Verhältnis als erfüllt, und q-teilige Symbole werden vorläufig als richtig unverzerrt empfangen anerkannt, wenn diese Summe der Kombination aus I Nullbinärsymbolen gleich ist. Es wird die Anzahl der lokalisierten Symbole N_{L} ⊂ [0, n] sowie die Anzahl der erfüllten Verhältnisse N_{c} (N_{c} ⊂ [0.2^{n-k} - 1]) berechnet. Für jedes q-teilige Symbol mit der Nummer i wird die Anzahl der erfüllten Verhältnisse berechnet, wobei dieses Symbol Mᵢ vorhanden war.

Diese Reihenfolge der Lokalisierungsschritte hat folgende Eigenschaft. Wenn die Anzahl der verzerrten q-teiligen Symbole den Wert von t = d - 2 nicht übertrifft, dann werden alle richtig empfangene Symbole in Mengen von mindestens n - d + 2 lokalisiert. Dabei sind diese Symbole in mindestens drei erfüllten Prüfverhältnissen vorhanden (bei t = d - 2 - in drei Prüfverhältnissen, bei t = d - 3 - in fünf Prüfverhältnissen, bei t = d - 4 - in sieben Prüfverhältnissen usw.). Das ist eine Bedingung, um die Richtigkeit (Fehlerfreiheit) der Lokalisierung der Symbole zu prüfen. Wenn die Lokalisierung richtig ausgeführt ist, gehört jedes der Symbole zu einer gleichen Anzahl von erfüllten Verhältnissen. Bei der Lokalisierung ist eine Fehlerwahrscheinlichkeit von P_{fe} ≤ q zulässig. Wenn nach der Verzerrung von zwei oder mehreren q-teiligen Symbolen eine Situation entsteht, bei der die Unterschiede von übertragenen Werten von zwei (oder mehreren) q-teiligen Symbolen sich von den übertragenen Werten nach der stochastischen Rücktransformation (sie werden als umgewandelte Vektoren des Fehlers e' bezeichnet) so sind, dass die Summe nach dem Modul 2 eine Reihenfolge aus I binären Nullsymbolen ergibt, dann wird in diesem Fall das Prüfverhältnis trotz einer Verzerrung von zwei (oder mehreren) Symbolen erfüllt. Aber die Ergebnisse der Lokalisierung verändern sich wesentlich. Erstens wird die Anzahl der "lokalisierten" Symbole größer als bei der entsprechenden Anzahl der erfüllten Verhältnisse sein. Zweitens wird die Anzahl der erfüllten Verhältnisse Mᵢ, wobei jedes Symbol i gehört, unterschiedlich für unterschiedliche Symbole sein. Die Reihenfolge der Kontrolle der Richtigkeit der Lokalisierung beruht auf diesen Besonderheiten. Es soll betont werden, dass der Code es ermöglicht, die maximale Anzahl t = d - 2 bei einer Fehlerwahrscheinlichkeit von P_{fe} ≤ q ⁻¹ zu korrigieren. Wenn tatsächlich t = d - 3 Fehler vorliegen (ein Fehler weniger als maximal möglich), dann werden fünf Verhältnisse erfüllt. Die wirklich erreichte Gültigkeit der Dekodierung des Blocks wird mit einer Fehlerwahrscheinlichkeit von P_{fe} ≤ q² eingeschätzt, was um das q-fache weniger ist usw.

So wird die Kontrolle der Richtigkeit der Lokalisierung der Codeblöcke durch eine Prüfung der Bedingungen N_{c}=2^{r-t*}-1, t*≤-2 ausgeführt, wobei t*= n - N_{I}, d der Code-abstand des binären (n, k)-Codes für die Codeblöcke ist. Dabei wird die Richtigkeit der Lokalisierung von einzelnen q-teiligen Symbolen durch eine Prüfung der Bedingung M₁ (/*) > S_{q}(t*) kontrolliert, wobei S_{q}(t*) die Schwellenwerte der Anzahl der erfüllten Verhältnisse für ein q-teiliges Symbol bei einem Sollwert t* sind. Symbole, für die die Bedingung nicht erfüllt wird, werden gelöscht und der Wert N_{I} wird um die Anzahl der gelöschten Symbole reduziert.

Die Wiederherstellung der Integrität von Codeblöcken (oder die Korrektur der nicht lokalisierten und gelöschten Symbole mit einer geforderten Gültigkeit) wird folgenderweise durchgeführt: Der Wert des korrigierten Symbols wird durch die Werte der gültig lokalisierten oder vorher korrigierten Symbole dargestellt. Dafür wird ein Prüfverhältnis ausgewählt, zu welchem ein zu korrigierendes Symbol und andere nur gültig lokalisierte oder vorher korrigierte Symbole gehören. Der Wert des korrigierten Symbols wird durch Addieren nach dem Modul 2 der Werte der lokalisierten und vorher korrigierten Symbole berechnet, die zu dem ausgewählten Prüfverhältnis gehören.

Die Optimalität des Codes, der im diskreten Kanal verwendet wird, wird geprüft, um eine maximale Übertragungsgeschwindigkeit sicherzustellen.

Für jeden Zustand eines diskreten Duplexkanals gibt es einen optimalen Code. Wenn dieser verwendet wird, ist die effektive Übertragungsgeschwindigkeit im Datenübertragungskanal mit einer Rückmeldeleitung maximal.

Für Kanäle mit unterschiedlicher Qualität (Wahrscheinlichkeit der Verzerrung des binären Symbols P₀) kann beispielsweise folgende Gesamtheit der Codes verwendet werden, die die Übertragungsgeschwindigkeit maximiert:
- bei P₀ der Größenordnung 10⁻¹ dem Code (8, 2, q) oder einer zweifachen Übertragung (m = 2) des Codes (8, 4) oder (16, 7);
- bei P₀ der Größenordnung 10⁻² dem Code (8, 4, q) oder (16, 7);
- bei P₀ der Größenordnung 10⁻³ dem Code (16, 11, q);
- bei P₀ der Größenordnung 10⁻⁴ dem Code (32, 26, q);
- bei P₀ der Größenordnung 10⁻⁵ dem Code (128, 120, q);
- bei P₀ der Größenordnung 10⁻⁶ dem Code (256, 247, q);
- bei P₀ der Größenordnung 10⁻⁷ dem Code (512, 502, q);

Die laufende Kontrolle der Codeoptimalität basiert auf einer Analyse der Anzahl der Blöcke, wenn bei der Dekodierung der Blöcke die Integrität der Information nicht wiederhergestellt werden konnte (Die Fehler können nicht komplett korrigiert werden, wenn die Fehlerrate die Korrigierfähigkeit des Codes überschreitet). Formal wird das in Form der Errechnung der Anzahl der Blöcke N_{OT} dargestellt, bei welchen die Integrität mit einer notwendigen Gültigkeit im Kanal auf einer Länge G der zuletzt empfangenen Blöcke durch den eingesetzten Code nicht wiederhergestellt wurde. Nach dem Empfang des nächsten Blocks mit der nicht wiederhergestellten Integrität wird der Anteil solcher Blöcke aus α = N_{OT}/ G berechnet. Die Optimalitätsbedingungen für den eingesetzten Code werden in Form des Verhältnisses βₘᵢₙ ≤ α ≤ βₘₐₓ geprüft. Wenn βₘᵢₙ ≥ α, wird eine Entscheidung getroffen, ob der eingesetzte Code durch einen störanfälligeren Code ersetzt wird. Wenn α ≥ βₘₐₓ, wird eine Entscheidung getroffen, ob der eingesetzte Code durch einen weniger störanfälligen Code ersetzt wird. Die bei der Projektierung ausgewählte untere und obere Schwellengrenze für eine Optimalität von βₘᵢₙ und βₘₐₓ hängen von den Eigenschaften des Protokolls für die Übertragungsteuerung in einem Duplexkanal ab. Die Schwellengrenzen haben Werte um 0,1 bzw. 0,5.

Betrachten wir die Reihenfolge der Sicherstellung einiger Gültigkeitsstufen für einen unveränderten Code näher. Es sollen Bose-Chaudhuri-Hocquenghem-Codes (16, 7) mit einem Codeabstand von d = 6 bei einer Länge des q-teiligen Symbols I = 32 Bits verwendet werden.

Wenn für diesen Betriebsmodus (bei der Übertragung dieser Nachricht) eine Fehlerwahrscheinlichkeit von 10⁻⁹ ausreichend ist, dann werden alle Blöcke mit korrigierten Fehlern (bei der Fehlerrate 1 bis 4) an die Benutzer geliefert und im Rückkopplungskanal quittiert. Wenn eine Fehlerwahrscheinlichkeit von unter 10⁻¹⁸ notwendig ist, dann werden Blöcke unter korrigierten Fehlern von 1 bis 3 an die Benutzer geliefert und quittiert. Die Blöcke mit dem Verhältnis des korrigierten Fehlers von 4 werden im Rückkopplungskanal nicht quittiert und werden wieder gemäß einem verwendeten Austauschprotokoll übertragen. Ein Block mit 4 korrigierten Fehlern wird dabei für eine weitere Dekodierung im Modus der Kopiendekodierung zusammen mit dem wiederholt übertragenen Wert dieses Blocks gespeichert. Dabei wird angenommen, dass alle Hardware- und Algorithmuslösungen im Datenübertragungskanal nicht verändert werden. Ausgeschlossen ist eine Einstellung der Prozedur zur Filterung der Blöcke am Ausgang eines Dekodiergeräts bei der Ausgabe an den Benutzer.

Die wichtigste Funktion Randomisierung (stochastische Transformation) wird auf jede mögliche Weise ausgeführt, um die Eigenschaft des q-teiligen symmetrischen Kanals, d. h. die Transformation des Fehlervektors im q-teiligen Symbol in einen seiner möglichen Werte mit der gleichen Wahrscheinlichkeit sicherzustellen. Die Anwendung dieser Funktion stellt eine garantierte Gültigkeit der an den Benutzer gelieferten Information in einem beliebigen Kanal sicher.

Die Randomisierung kann mit Hilfe der Randomisierungseigenschaft durch einen Generator mit einer konstanten Anfangsausfüllung, die vor dem Generatorstart eingestellt wird, sowie bei der Verwendung einer Anfangsausfüllung, die durch das System der kryptographischen Schlüssel (geheim oder öffentlich) bestimmt wird, erreicht werden.

Die Randomisierungswerte ξ mit einer Länge von I können mit Hilfe jeder bekannten technischen Lösung erzeugt werden. Eine der Realisierungsvarianten kann ein Generator auf der Basis des Registers mit nichtlinearen Funktionen in Rückkopplungskreisen auf der Basis von Tabellen mit einer zufälligen Ausfüllung [Patent der Russischen Föderation Nr. 2246129] sein. Das Anfangsausfüllen der Tabellen mit zufälligen Zahlen und ein Schieberegister mit Rückmeldekanal stellen einen Schlüssel für einen kryptographischen Schutz dar.

Die Randomisierung kann eine kryptographische Funktion darstellen, die Folgendes sicherstellt:
- Auf der Senderseite wird bei der Übertragung einer beliebigen Information, auch gleicher Informationskombinationen, in einem Codeblock der Übergang zu den Zufallssignalen im Kommunikationskanal sichergestellt. Das ermöglicht eine absolute Vertraulichkeit gemäß Shannon;
- auf der Empfängerseite wird innerhalb jedes verzerrten q-teiligen Symbols mit einer Länge von I Bits das Symbol in eine der 2^{I} - 1 zufälligen Kombinationen (außer der übertragenen Kombination) mit gleicher Wahrscheinlichkeit umgewandelt. Das ermöglicht, eine garantierte Zuverlässigkeit P_{fe} < q⁻¹ in einem zufälligen Kanal zu erreichen. So kann jede (durch die Auswahl des I-Wertes) notwendige Zuverlässigkeit erreicht werden, auch eine Zuverlässigkeit, die gegen Null strebt.

Der Schutz gegen das Aufdrängen einer falschen Information unter den Bedingungen gleichzeitig lösbarer Aufgaben zur Erhöhung der Effizienz der Informationsübertragung über einen Kanal jeder Qualität, (darunter bei einer wesentlichen Reduzierung der Qualität und des Schutzes gegen destruktive Einwirkungen) wird durch die Funktionen einer Codewiederherstellung der Integrität (direkte Fehlerkorrektur mittels des Codes) bei einer garantierten Gültigkeit solcher erfolgreichen Wiederherstellung bei jedem Störungscharakter ausgeführt. D. h., wenn die Anzahl der verzerrten q-teiligen Symbole die Korrigierfähigkeit des Codes nicht übertrifft, werden diese Verzerrungen zuverlässig korrigiert. Wenn die Anzahl der verzerrten Symbole die Korrigierfähigkeit des Codes übertrifft, wird zuverlässig abgesagt, diese Verzerrungen zu korrigieren, aber die verzerrte Information wird nicht an den Benutzer geliefert. Wenn die Anzahl der Fälle mit der Absage zur Korrektur der Fehler größer als der obere Schwellenwert ist, welcher bei der Projektierung ausgewählt wird, wird gemäß der Adaptationsprozedur auf einen "stärkeren" Code umgeschaltet, der eine niedrigere Codegeschwindigkeit (Verhältnis R = k/n) aufweist.

Wenn die Anzahl der Fälle mit der Absage zur Korrektur der Fehler geringer als der niedrige Schwellenwert ist, welcher bei der Projektierung ausgewählt wird, dann wird gemäß der Adaptationsprozedur auf einen "schwächeren" Code umgeschaltet, der eine höhere Codegeschwindigkeit (Verhältnis R = k/n) aufweist. Die bei der Projektierung ausgewählten oberen und unteren Schwellenwerte für die Optimalität haben den Wert 0,5, bzw. 0,1.

Bei einer Funktionsstörung des Datenübertragungskanals auf Grund einer abrupten Reduzierung der Qualität des Kanals ist es unmöglich, den Austausch mit Hilfe früher ausgewählter Codeeigenschaften durchzuführen. Der Austausch wird mit einem Wiederholungscode fortgesetzt, der eine Anfangsprüfung des Kanalzustands vornimmt, wie oben beschrieben ist.

Das Verfahren zur Informationsübertragung und zum Informationsschutz hat eine Reihe von technischen Lösungen als Analoga, die sich auf störungssichere Codierung, auf Mittel zur Authentifizierung der Nachrichten und Teilnehmer und auf Mittel zur Sicherstellung der Funktionszuverlässigkeit der Informations- und Funksysteme beziehen. Unten sind Eigenschaften und Besonderheiten des Verfahrens angeführt, die es ermöglichen, dieses Verfahren mit ähnlichen Verfahren zu vergleichen.

Die zu lösenden technischen Aufgaben werden im Rahmen des Verfahrens in folgende Gruppen aufgeteilt:
- Weite Anwendung des Fehlerkorrekturmodus in realen Funkkanälen (zur Wiederherstellung der Integrität);
- Integrierter Schutz im Rahmen eines Algorithmus bei einer einfachen Ergänzung;
- Erhöhung der Störungssicherheit, darunter auch bei einer Reduzierung der Qualität des Kanals;
- Anpassungsfähigkeit der Funktionen des Datenübertragungskanals im Rahmen eines Protokolls (Einrichtungen) mit einer Beschränkung des ganzen Bereichs der Kanalqualität;
- Erhöhung der Effizienz der Datenübertragung (effektive Geschwindigkeit, Echtzeitmodus);

Es werden nun die Besonderheiten bei der Anwendung des Verfahrens unter typischen Bedingungen von Informations- und Funksystemen betrachtet.

Es gibt grundlegende Varianten der Anwendung des Verfahrens unter folgenden Bedingungen:
- öffentliche Duplexkanäle,
- Simplexkanäle (unidirektional),
- Duplexkanäle in Echtzeit,
- Kanäle mit sehr niedriger Qualität,
- Datenübertragungskanäle, um eine sehr hohe Gültigkeit sicherzustellen,
- Speichermedien für die Information (Datenspeicher der Rechner, Datenbanken u. a.),
- Protokolle der Sitzungsschicht für die Kontrolle und die Wiederherstellung der Integrität der Nachrichten.

Der Fehlerkorrekturmodus findet aus zwei Hauptgründen in realen Funkkanälen (zur Wiederherstellung der Integrität) eine weite Anwendung:
- Das Vorhandensein einer oberen Grenze für die Fehlerwahrscheinlichkeit nach der Dekodierung in einem beliebigen Funkkanal. Die obere Grenze kann frei eingestellt werden;
- eine schnelle Code-Realisierung wegen des binären Charakters der Funktionen unabhängig von der Größe der Codebasis.

Integrität des Schutzes mit folgenden Besonderheiten:
- Eine einfache Ergänzung zur Lösung aller Aufgaben, die eine Redundanz erfordern (Schutz gegen Fehler, Schutz gegen Aufdrängen, Kontrolle und Wiederherstellung der Integrität in den Kanälen und den Datenbanken, Kontrolle der Gültigkeit);
- Verwendung von Informationselementen (q-teilige Symbole), die für alle Schutzaufgaben einheitlich sind und als Symbol eines störungssicheren Codes betrachtet werden;
- Verwendung eines Schlüsselblocks für die Aufgabe eines kryptographischen Schutzes gegen ein Aufdrängen;
- Verwendung einheitlicher Randomisierungsoptionen (kryptographische Umwandlung) zur Lösung aller Aufgaben eines kryptographischen Schutzes (Schutz gegen Einblick, Schutz gegen Aufdrängen einer falscher Information, Authentifizierungskontrolle, Kontrolle und Wiederherstellung der Integrität).

Erhöhung der Störungssicherheit, darunter auch bei der Reduzierung der Qualität des Kanals:

Die Übertragung von Nachrichten in einem Duplexkanal mit einer maximalen Geschwindigkeit und einer geforderten garantierten Gültigkeit, wünschenswert mit einigen Stufen (für die ganze Information nicht schlechter als Pₜᵣ₁, für eine besonders wichtige Information nicht schlechter als Pₜᵣ₂).

Bei der Lösung des Problems Störungssicherheit entstehen drei Aufgaben, die sich aus unterschiedlichen Bedingungen zur Anwendung des Verfahrens gemäß einer Universalität des Verfahrens ergeben.

Erstens soll eine beliebige, vorher festgelegte Gültigkeit in Duplexkanälen mit relativ hoher Qualität erreicht werden, ohne die effiziente (relative) Übertragungsgeschwindigkeit zu reduzieren. Die Übertragungsgeschwindigkeit soll nicht wesentlich unter der Übertragungskapazität des Kanals liegen.

Zweitens soll der Kanal eine hohe Störungssicherheit bei Beibehaltung einer notwendigen Gültigkeit haben, um eine beliebige, vorher festgelegte Zuverlässigkeit der Lieferung einer Nachricht durch einen Simplexkanal (ohne Rückkopplungsleitung) sicherzustellen.

Drittens soll dieses Verfahren nicht nur bei technisch möglichen hohen Datenübertragungsgeschwindigkeiten einsetzbar sein. Es soll verzögerungsfrei (möglichst einfach bei der Realisierung) sein.

Es wird vorgeschlagen, eine m-fache Übertragung von Codeblöcken und eines Dekodierungsmodus für Kopien zu verwenden, um die Nachrichten im Simplexkanal zu übertragen. Dabei wird die notwendige Sicherheit der Lieferung der Nachricht bei einer eingegebenen Qualität des Kanals sichergestellt.

In Simplexkanälen stellt die Verwendung des Verfahrens eine frei festgelegte Zuverlässigkeit der Lieferung der Nachricht bei einer garantierten Gültigkeit nach einer ersten Übertragung sicher, auch in einem Kanal mit niedriger Qualität, bei dem der Modus der Dekodierung von Kopien verwendet werden kann. Der Modus der Dekodierung der Kopien stellt eine maximal mögliche Korrigierfähigkeit für die Konstruktion eines erweiterten Codes sicher. Wenn der binäre Quellcode zum Beispiel einen Codeabstand von d = 4 (Hamming-Code mit zusätzlicher Paritätsprüfung) aufweist, korrigiert der stochastische Quellcode (m = 1) zwei verzerrte q-teilige Symbole. Der erweiterte stochastische Code mit zweifacher Wiederholung des Quellcodes (m = 2) ermöglicht es, sechs verzerrte q-teilige Symbole (t = 6) zu korrigieren. Bei einer dreifachen Wiederholung des Blocks werden 10 Symbole korrigiert. Im allgemeinen Fall werden nicht weniger als t = md - 2 Symbole korrigiert.

Bei der Realisierung des Verfahrens ist ein Echtzeitmodus in Duplexkanälen möglich, auch wenn die Qualität des Kanals reduziert wird. Das Verfahren wird durch die Auswahl des Codes mit einem großen Codeabstand in einem Block oder durch die gleichzeitige Übertragung von 2, im allgemeinen Fall von m gleichen Codeblöcken mit einer weiteren Dekodierung nach dem Algorhytmus der Dekodierung der Kopien realisiert, wenn die Anzahl der korrigierten Fehler md-2 beträgt. D. h. für einen (n, k, q, m)-Code auf der Basis eines binären Quell (n, k)-Codes mit einem Codeabstand d, welcher einen Codeabstand md hat, bleibt die Korrigierfähigkeit erhalten, die sich um den Wert 2 vom Codeabstand unterscheidet.

Anpassungsfähigkeit der Funktionen des Datenübertragungskanals im Rahmen eines Protokolls (Einrichtungen) mit einer Beschränkung des gesamten Bereichs der Kanalqualität durch:
- das Vorhandensein von Parameter eines Quellcodes, wobei:

- es möglich ist, sicher und genau die Qualität des verwendeten Kanals zu ermitteln;
- es möglich ist, einen optimalen Code für den Kanal mit jeder Qualität mit e Verzerrungswahrscheinlichkeit des q-teiligen Symbols von 0,5-0,6 bis zu einem beliebigen kleinen Wert dieser Wahrscheinlichkeit (bezogen auf die Verzerrungswahrscheinlichkeit des binären Symbols von 0,1 bis einen beliebigen kleinen Wert, beispielsweise bis 10⁻⁷) auszuwählen. Dabei kann die Fehlerrate nach jedem Gesetz verteilt werden.
- einen einheitlichen Charakter der Beschreibung von Eigenschaften des Kanals, in welchem Anpassungsfunktionen aufgebaut werden können, sowohl beim Einschalten des Datenübertragungskanals als auch beim Betrieb des Kanals:

- Beim Einschalten wird der Wiederholungscode, beispielsweise mit den Eigenschaften (n, I, q) verwendet. Das Vorhandensein von zwei oder mehreren unverzerrten q-teiligen Symbolen aus n (zum Beispiel n = 100) ermöglicht es, zuverlässig und sicher die Ausgangsqualität des Kanals zu ermitteln;
- nach dem Beginn des Betriebs kann durch die Ermittlung der Anzahl und des Anteils (Wahrscheinlichkeit) der Absagen und der Verzerrungen im Kanal im Beobachtungsbereich eine zuverlässige Schlussfolgerung gezogen werden, dass der Zustand des Kanals geändert wurde und der verwendete Code auf einen "stärkeren" (mit der größeren Korrigierfähigkeit) oder im Gegensatz auf einen "schwächeren" Code gewechselt werden soll. Der neue Code soll es ermöglichen, bei einer größeren Codegeschwindigkeit im veränderten Kanal schneller Informationen zu übertragen (mit einer größeren effektiven Geschwindigkeit).

Die Erhöhung der Effizienz der Datenübertragung (effektive Geschwindigkeit, Echtzeitmodus) wird durch eine praktische Verwendung des Modus der Wiederherstellung der Integrität der Information (direkte Fehlerkorrektur mit einer garantierten Gültigkeit) erreicht.

Die genannten Eigenschaften des Verfahrens werden durch die Anwendung der Verfahren aus der Spieltheorie durch Verwendung von "gemischten Strategien" und "randomisierten Strategien" im System zur Übertragung oder zur Verarbeitung von Information erreicht. Es wird eine Gesamtheit der abwechselbaren Signalkonstruktionen verwendet, um einen garantierten Charakter der Systemeigenschaften sicherzustellen, d. h. es werden Code- und Schlüsselensembles verwendet:
- Möglichkeit einer einfachen Hard- und Softwarerealisierung;
- schnelle Soft- und Hardwarerealisierung;
- einheitliche Gesamtheit der Funktionen zur Informationsbearbeitung;
- eine höhere Effizienz auf Grund von:
   - einer einfachen Ergänzung zur Lösung aller Aufgaben, die eine Redundanz erfordern (Schutz gegen Fehler, Schutz gegen Aufdrängen, Kontrolle und Wiederherstellung der Integrität in Kanälen und Datenbanken, Kontrolle der Gültigkeit);
   - der Verwendung von Informationselementen (q-teilige Symbole), die für alle Schutzaufgaben einheitlich sind und als Symbol eines störungssicheren Codes betrachtet werden. Verwendung eines Schlüsselblocks für die Aufgabe eines kryptographischen Schutzes gegen Einblick;
   - Verwendung einheitlicher Funktionen einer kryptographischen Transformation zur Lösung aller Aufgaben eines kryptographischen Schutzes (Schutz gegen Einblick, Schutz gegen Aufdrängen falscher Information, Authentifizierungskontrolle, Kontrolle und Wiederherstellung der Integrität).

Die Übertragung und der integrierte Schutz der Information werden gemäß der Erfindung dank der folgenden Besonderheiten und Eigenschaften der mathematischen Basis des Verfahrens sichergestellt:
- garantierter Charakter der Eigenschaften des Verfahrens zur Übertragung und zum Schutz der Information;
- Kombination der Codeergänzung und kryptigraphischen Transformation im Rahmen eines einheitlichen Verfahrens zum Informationsschutz;
- Vorhandensein der Parameter eines Quellcodes, wobei:
   - es möglich ist, sicher und genau die Qualität des verwendeten Kanals zu ermitteln;
   - es möglich ist, einen optimalen Code für den Kanal mit jeder Qualität mit der Verzerrungswahrscheinlichkeit des q-teiligen Symbols von 0,5 bis zu einem beliebigen kleinen Wert dieser Wahrscheinlichkeit (bezogen auf die Verzerrungswahrscheinlichkeit des binären Symbols von 0,1 bis zu einem beliebigen kleinen Wert, beispielsweise bis 10⁻⁷) auszuwählen. Dabei kann die Fehlerrate nach jedem Gesetz verteilt werden.
   - einheitlicher Charakter der Beschreibung von Eigenschaften des Kanals, in welchem Anpassungsfunktionen aufgebaut werden können, sowohl beim Einschalten des Datenübertragungskanals als auch beim Betrieb des Kanals:

   - beim Einschalten wird ein Wiederholungscode, beispielsweise mit Eigenschaften (100, I, q), verwendet. Das Vorhandensein von zwei oder mehreren unverzerrten q-teiligen Symbolen aus 100 ermöglicht es, zuverlässig und sicher die Ausgangsqualität des Kanals zu ermitteln;
   - nach dem Beginn des Betriebs kann durch die Ermittlung der Anzahl und des Anteils (Wahrscheinlichkeit) der Absagen und der korrigierten Verzerrungen im Kanal im Beobachtungsbereich eine zuverlässige Schlussfolgerung gezogen werden, dass der Zustand des Kanals geändert wurde und der verwendete Code auf einen "stärkeren" (mit der größeren Korrigierfähigkeit) oder im Gegensatz auf einen "schwächeren" Code gewechselt werden soll. Der neue Code soll es ermöglichen, bei einer größeren Codegeschwindigkeit im veränderten Kanal schneller Informationen zu übertragen (mit einer größeren effektiven Geschwindigkeit).
- Die Anwendung der Verfahren aus der Spieltheorie durch Verwendung einer "gemischten Strategie" und einer "randomisierten Strategie" im System zur Übertragung oder Verarbeitung von Informationen, d. h. die Gesamtheit der abwechselbaren Signalkonstruktionen, stellt einen garantierten Charakter der Systemeigenschaften sicher, d. h. es werden Code- und Schlüsselsysteme verwendet.
- Möglichkeit einer einfachen Hard- und Softwarerealisierung;
- schnelle Soft- und Hardwarerealisierung;
- einheitliche Gesamtheit der Funktionen zur Informationsbearbeitung;
- höhere Effizienz auf Grund von:
   - einer einfachen Ergänzung zur Lösung aller Aufgaben, die eine Redundanz erfordern (Schutz gegen Fehler, Schutz gegen Aufdrängen, Kontrolle und Wiederherstellung der Integrität in Kanälen und Datenbanken, Kontrolle der Gültigkeit)
   - der Verwendung von Informationselementen (q-teilige Symbole), die für alle Schutzaufgaben einheitlich sind und als Symbol eines störungssicheren Codes betrachtet werden. Die Verwendung eines Schlüsselblocks für die Aufgabe eines kryptographischen Schutzes gegen Einblick;
   - Verwendung einheitlicher Funktionen einer kryptographischen Transformation zur Lösung aller Aufgaben eines kryptographischen Schutzes (Schutz gegen Einblick, Schutz gegen Aufdrängen falscher Information, Authentifizierungskontrolle, Kontrolle und Wiederherstellung der Integrität).

Dabei wird die Aufgabe gestellt, jede Art des Schutzes im Vergleich zu den bekannten Schutzmitteln effizienter zu realisieren. Dabei sollen die Schutzmittel eine neue Qualität bei den garantierten Parametern des Informationssystems aufweisen. Darunter fallen eine garantierte hohe Gültigkeit bei einem gestreuten Charakter der Verzerrungen (Fehlerwahrscheinlichkeit in der Information, die der Benutzer bekommt, soll 10⁻⁹, 10⁻⁸ und weniger sein), eine garantierte Übertragung der Nachrichten durch jeden Kanal mit einer Übertragungskapazität über Null durch Verwendung einer Anpassung an die Kanaleigenschaften (die mit Hilfe der Wahrscheinlichkeit der Verzerrung des q-teiligen Symbols beschrieben werden) und eine garantierte Standfestigkeit des Schutzes und andere Eigenschaften.

Durch die Realisierung des Verfahrens wird Folgendes sichergestellt:
- in einer Hardware (Einrichtung) werden Mittel zur Erreichung unterschiedlicher Anforderungen zur Gültigkeit vereinigt. Dabei wird die notwendige Gültigkeit mit Hilfe eines Filters einfach eingestellt. Beim Empfang wird die Gültigkeit durch die Ausgabe von Blöcken mit einer festgelegten Anzahl von korrigierten Symbolen gefiltert;
- in einem funktionierenden Gerät mit einem bestimmten Wert der Länge des q-teiligen Symbols kann eine Fehlerwahrscheinlichkeit bei der Dekodierung durch Zuschaltung eines neuen Codes mit einem großen, im Vergleich zu dem verwendeten, Codeabstand des binären Quellcodes d reduziert werden. Das wird durch Speicherung der binären Prüfmatrize H eines solchen Codes im Gerät erreicht;
- es kann eine beliebig hohe Zuverlässigkeit erreicht werden, ohne die Coderedundanz in allen Fällen zu verändern. Wenn für einen zyklischen Code die Fehlerwahrscheinlichkeit durch die Eingabe der Anzahl der redundanten Symbole log₂ P_{fe} ermittelt werden kann, dann kann in unserem Fall die minimale Länge des q-teiligen Symbols eingenommen werden. Die überhöhte Zuverlässigkeit wird durch einen oder zwei Codes mit einem großen Codeabstand sichergestellt. Die Zuverlässigkeit wird durch die Formel P_{fe} =2^{-(d-1-t)/} ermittelt, d. h. durch eine Korrektur der kleineren als der maximal möglichen Anzahl der verzerrten q-teiligen Symbole.

Zum Beispiel, wenn die Länge des q-teiligen Symbols I = 32 Bits beträgt, kann ein folgender Satz der Eigenschaften sichergestellt werden. Im Modus der Fehlererkennung (ein q-teiliges Prüfsymbol), im Modus der Dekodierung der Kopien und der Fehlerkorrektur mit maximaler Korrigierfähigkeit (t = d - 2) wird eine Fehlerwahrscheinlichkeit von maximal 10⁻⁹ sichergestellt. Bei der Reduzierung der Anzahl der korrigierten Symbole um 1 (t = d - 3, beispielsweise für Hamming-Codes mit zusätzlicher Paritätsprüfung bei d = 4 durch die Reduzierung der Korrigierfähigkeit in zwei bis einem verzerrten q-teiligen Symbol) wird die Wahrscheinlichkeit des Dekodierungsfehlers auf 10⁻¹⁸ reduziert. Um ein höheres Niveau einer sichergestellten Zuverlässigkeit (Reduzierung der Wahrscheinlichkeit des Dekodierungsfehlers) zu erreichen, kann ein Code mit einem größeren Codeabstand d verwendet werden. Mit Hilfe des Bose-Chaudhuri-Hocquenghem-Codes (16, 7) mit einem Codeabstand von 6 können folgende Werte der Wahrscheinlichkeit des Dekodierungsfehlers bei I = 32 erreicht werden. Bei einer Korrektur von vier, drei, zwei oder einem verzerrten q-teiligen Symbolen/Symbol beträgt die Fehlerwahrscheinlichkeit nach der Dekodierung 10⁻⁹ bzw. 10⁻¹⁸, 10⁻²⁷ und 10⁻³⁶.

Dieses Verfahren zur Fehlerkorrektur ermöglicht es, die Information über einen Kanal mit einer niedrigen, praktisch zufälligen Qualität mit einer Übertragungskapazität über Null zu liefern. Die Kapazitäten des stochastischen Codes im Kanal mit einer beliebig niedrigen Qualität können mittels eines Wiederholungscodes (n, I) veranschaulicht werden. Der Wiederholungscode ermöglicht es, die Nachricht mit einer Größe von einem q-teiligen Symbol (I Bits) mit einer Verzerrung von bis zu n-2 q-teiligen Symbolen zu liefern. Zum Beispiel wenn n = 20, dann ist die Dekodierung bei einer Verzerrung von 1 bis 18 von 20 q-teiligen Symbolen erfolgreich. Dabei wird eine hohe Zuverlässigkeit bei der Entscheidung während der Dekodierung sichergestellt. Zum Beispiel, wenn ein Wiederholungscode (20, 1) während der Dekodierung zeigt, dass 10 Symbole verzerrt sind und als richtiges Symbol an den Benutzer ein Wert geliefert wird, der mit 10 anderen Symbolen übereinstimmt, dann beträgt die Fehlerwahrscheinlichkeit der Dekodierung q⁻⁹.

Das beschriebene Verfahren hat folgende Vorteile:
1) Es werden die Integration der Mittel zur Übertragung und zum Schutz der Information sowie die Integration der Hard- und Software zur deren Realisierung sichergestellt.
2) Es wird eine beliebig kleine Fehlerwahrscheinlichkeit, die annähernd Null ist, bei der Dekodierung im Kanal mit einem beliebigen Charakter und beliebigem Gesetz der Störungsverteilung sichergestellt.
3) Es wird eine notwendige Wahrscheinlichkeit sichergestellt, die nahe 1 liegt, um die Nachricht nach der ersten Übertragung im Modus der Fehlerkorrektur, darunter auch im Modus der Dekodierung der m Kopien von Codeblöcken im Kanal mit niedriger Qualität zu liefern.
4) Es wird ein stabiler Informationsaustausch im Kanal mit einer unbekannten Charakteristika sichergestellt. Die Übertragungskapazität des zur Verfügung gestellten Kanals mit der Übertragungskapazität über Null ist für den Informationsaustausch nach diesem Verfahren ausreichend. D. h. der Kanal soll über eine Verknüpfungskapazität verfügen, sowie die Information übertragen können.
5) Es wird eine maximale Geschwindigkeit und eine effektive Geschwindigkeit für die Informationsübertragung für diesen Kanal sichergestellt. Die Geschwindigkeit nähert sich der Übertragungskapazität des Kanals an.
6) Durch die Verwendung eines Satzes aus M stochastischen Codes mit Wiederherstellung einer Integrität der Information (Fehlerkorrektur) werden Vorteile erreicht, die aus den Eigenschaften dieser Codes stammen, und zwar:
   - Erhöhung der Effizienz der Informationsbearbeitung, wobei:
      - eine garantierte Zuverlässigkeit im Modus der Fehlerkorrektur bei einem beliebigen Charakter und eine Intensität der Verzerrungen im Kommunikationskanal sichergestellt wird;
      - die effiziente Geschwindigkeit der Datenübertragung erhöht wird;
      - der Echtzeitmodus sichergestellt wird.
   - die hohe Geschwindigkeit der Bearbeitung der Information, die die physische Geschwindigkeit im Kommunikationskanal (in Bit pro Sekunde) ist, wird nicht unterdrückt;
   - eine hohe Geschwindigkeit bei der Bearbeitung im Rechner, beispielsweise bei der Verschlüsselung vor dem Speichern auf einem Datenträger (Entschlüsselung nach dem Ablesen von den Datenträgern);
   - Sicherstellung des integrierten Schutzes im Rahmen einer einheitlichen Gesamtheit der Schritte zur Bearbeitung der Information bei einer einfachen Ergänzung, und zwar:
      - Schutz gegen die Verzerrungen in den Kommunikationskanälen (Netzen);
      - kryptographischer Schutz gegen Einblick;
      - kryptographischer Schutz gegen Aufdrängen einer falschen Information;
      - Kontrolle und Wiederherstellung der Integrität der Information;
      - Abgrenzung des Zuganges zur Information durch die Benutzer;
      - Schutz gegen absichtliche destruktive Einwirkungen auf die Information in den Informationssystemen.
   - Sicherstellung einer hohen kryptographischen Stabilität beim Schutz der Information dadurch, dass folgende Eigenschaften erreicht werden:
      - Nach der Verschlüsselung und vor der Übergabe einer quasi zufälligen Reihenfolge der Signale in den Kommunikationskanal, unabhängig von der Statistik der einzelnen Buchstaben im Ausgangstext;
      - Verwendung einer komplizierten Umwandlung, die keine andere formelle Beschreibung hat, außer der Beschreibung der Ausfüllung der zufälligen Transformationstabellen;
      - Möglichkeit, die Anfangsausfüllung der zufälligen Tabellen als Schlüssel zu betrachten.
7) Es wird eine weite Verwendung der störungssicheren Codes mit einer direkten Fehlerkorrektur mit Hilfe eines Codes in den Kanälen mit einem beliebigen Verteilungsgesetz und mit einer beliebigen Intensität der Fehler im Kommunikationskanal, darunter im Fall einer absichtlichen Verzerrung erreicht, um destruktiv auf die Funkkanäle und Netze, sowie auf die Informationssysteme einzuwirken.

Für eine schnelle und effektive Realisierung der Randomisierung (stochastische Transformation) kann diese mit Hilfe der Schritte auf der Basis der Tabellen mit zufälliger Ausfüllung ausgeführt werden [5, 6]. Die Werte des Transformationsparameters ξ mit einer Länge von I können mit Hilfe eines Registers mit nichtlinearen Funktionen in den Rückkopplungskreisen auf der Basis der Tabellen mit zufälliger Ausfüllung generiert werden [7]. Bei der Realisierung des Verfahrens gilt eine Anfangsausfüllung der Tabellen mit zufälligen Zahlen und einem rückgekoppelten Schieberegister als Schlüssel des kryptographischen Schutzes.

Das Verfahren ermöglicht es, den Informationsaustausch in Duplex- und Simplexkanälen durchzuführen. Der Informationsaustausch kann unter beliebigen Übertragungsbedingungen ausgeführt werden, auch wenn andere Verfahren nicht eingesetzt werden können (niedrige Qualität des Kanals, absichtliche Störungen). Das Verfahren ermöglicht es, die Genauigkeit der Berechnung dieser Charakteristika durch die Randomisierung der Signale sicherzustellen und alle Funktionen zum Informationsschutz integriert mit einer höheren Effizienz unter allen möglichen Bedingungen im Rahmen eines Algorithmus der Informationsverarbeitung bei einer einfachen Ergänzung auszuführen.
- Das Verfahren kann in allen Fällen verwendet werden, in denen heutzutage störungssichere Codes mit Fehlererkennung und Korrektur, kryptographische Verfahren, Mittel zum Schutz gegen Aufdrängen falscher Information, Abgrenzung des Zugangs zur Information in den Informationssystemen, Schutz gegen destruktive Einwirkungen, Mittel zur Kontrolle und Wiederherstellung der Information in Datenbeständen eingesetzt werden. Das Verfahren wird sowohl in den Fällen mit einem integrierten Schutz (in Tunnelprotokollen und Sondersystemen) als auch in den Fällen verwendet, bei denen traditionell einzelne Aufgaben des integrierten Schutzes eingesetzt werden.
- Das Verfahren kann verwendet werden:
   - im Internet/Intranet;
   - in Netzen, die unterschiedliche Protokollstapel verwenden;
   - in Funknetzen und Kommunikationskanälen, darunter auch Breitband-Drahtlosnetzen wie Wi-Fi, WiMax;
   - in Beschallungssystemen, um die Störungsstabilität der Übertragung bei der Erweiterung des Bereichs der Erreichbarkeit des Signals sicherzustellen und die Benutzung des Netzes durch Teilnehmer zu kontrollieren;
   - in Betriebssystemen und Datenbanken;
   - in Mobilfunknetzen;
   - in Anwendungssoftware der Informations- und Steuerungssysteme u. a.

### Literaturverzeichnis

[1] Empfehlungen CCITT X.25 und ihre Anwendung in Informations- und Rechnernetzen. Beschreibung der Empfehlung X.25. Das Internationale Zentrum für wissenschaftliche und technische Information. Moskau, 1983.
[2] W.Peterson, E.Weldon. Error-correcting codes. Mir, Moskau, 1976.
[3] Sima W.M., Moldowjan A.A., Moldowjan N.A. Sicherheit der globalen Netztechnologien. - St.Petersburg; BHW-Peterburg, 2001.
[4] Romanets Ju.W., Timofeew P.A., Schangin W.A.. Schutz der Information in Computersystemen und Netzen. -Moskau: Radio i swjas, 1999.
[5] Patent der Russischen Föderation Nr. 2254685. Verfahren zur Chiffretransformation der Information. Erfinder Osmolovsky S.A., 2003.01.13.
[6] Patent der Russischen Föderation Nr. 2266622. Verfahren der Blockverschlüsselung der Information. Erfinder Osmolovsky S.A. Patentanmeldung der Russischen Föderation Nr. 2004108916/09 (009857), Priorität 29.03.2004.
[7] Patent der Russischen Föderation Nr. 2246129. Verfahren zum Generieren der Zufallszahlen. Erfinder Osmolovsky S.A., 2003.01.13.

## Patentansprüche

1. Verfahren zur Übertragung und zum integrierten Schutz von Informationen,
**dadurch gekennzeichnet,**
**dass** vor dem Beginn der Übertragung die Bedingungen für einen Informationsaustausch und die Qualität des Kanals festgelegt werden,
**dass** optimale Werte für die Parameter n, k und m eines benutzten stochastischen q-teiligen (n, k, q, m)-Codes auf der Basis eines (n, k) Binärcodes als Quelle mit I-Beschränkung (q = 2^{I}) und einer Übergabe der m-Blöcke des Codes mit gleichen Werten des Informationsteils ausgewählt werden,
**dass** die Information mit Hilfe des ausgewählten q-teiligen Codes kodiert wird,
**dass** die q-teiligen Symbole vor der Übergabe in den Kanal direkt randomisiert werden,
**dass** die q-teiligen Symbole beim Empfang der Information zurück randomisiert werden,
**dass** die Integrität und Authentifizierung der q-teiligen Symbole und Nachrichten sowie die Gültigkeit der vollständigen Symbole geprüft werden,
**dass** die Integrität in den m-Codeblöcken wiederhergestellt wird,
**dass** die gültigen q-teiligen Symbole nach der Verarbeitung der m-Codeblöcke für die Ausgabe an einen Verbraucher gespeichert werden,
**dass** geprüft wird, ob die Werte der Parameter n, k und m optimal sind und dass die Werte der Parameter n, k und m korrigiert werden.

2. Verfahren nach Anspruch 1,
**dadurch gekennzeichnet,**
**dass** die Übertragung der Information über alle Kanaltypen mit einer Übertragungskapazität über Null vorgenommen wird und
**dass** alle kontrollierten vorher festgelegten Eigenschaften der Informationsübertragung sichergestellt werden.

3. Verfahren nach Anspruch 1,
**dadurch gekennzeichnet,**
**dass** ein integrierter Informationsschutz als Schutz gegen Verzerrungen in den Kommunikationskanälen, Funknetzen und Informationsspeichern, als Authentifizierungsprüfung und Wiederherstellung der Integrität der Information, als Abgrenzung des Zuganges zur Information durch Benutzer, als kryptographischer Schutz gegen Einblick, als kryptographischer Schutz gegen ein Aufdrängen einer falschen Information, als Schutz gegen absichtliche destruktive Einwirkungen auf die Information in den Informationssystemen und als Sicherstellung der garantierten Informationseigenschaften des Systems durchgeführt wird.

4. Verfahren nach Anspruch 1,
**dadurch gekennzeichnet,**
**dass** die Qualität des verwendeten Kommunikationskanals oder Speichermediums für die Information mittels Übergabe des Blocks eines stochastischen q-teiligen Wiederholungscodes (n, I, q) analysiert wird,
**dass** die empfangenen q-teiligen Symbole symbolweise verglichen und die Anzahl der übereinstimmenden q-teiligen Symbole berechnet werden,
**dass** der Anteil der übereinstimmenden Symbole in Bezug auf die Länge des n-Codes berechnet wird und
**dass** die Parameter des Codes für eine Wiederherstellung der Integrität für die Übertragung der Information durch diesen Kanal nach dem berechneten Wert des Anteils unverzerrter q-teiliger Symbole ausgewählt werden.

5. Verfahren nach Anspruch 1,
**dadurch gekennzeichnet,**
**dass** die optimalen Parameter des Codes für öffentliche Duplexkanäle nach dem Kriterium maximaler Übertragungsgeschwindigkeit ausgewählt werden, wobei die vorher bestimmte Gültigkeit sichergestellt wird, die anhand der Wahrscheinlichkeit des Fehlers in der Information ermittelt und an den Informationsempfänger geliefert wird.

6. Verfahren nach Anspruch 1,
**dadurch gekennzeichnet,**
**dass** die optimalen Parameter des Codes für Simplexkanäle nach dem Kriterium Sicherstellung der notwendigen Sicherheit bei der Lieferung einer Nachricht ausgewählt werden, die anhand der Wahrscheinlichkeit der Lieferung einer Nachricht nach einer ersten Übertragung eingeschätzt wird, wobei die notwendige Gültigkeit sichergestellt wird.

7. Verfahren nach Anspruch 1,
**dadurch gekennzeichnet,**
**dass** die q-teiligen Signalsymbole bei der Übertragung für die Transformation der Symbolwerte in ein zufälliges Signal unabhängig von der übertragenen Information randomisiert werden und
**dass** beim Empfang die q-teiligen Symbole für die Transformation eines Fehlervektors des q-teiligen Symbols mit gleicher Wahrscheinlichkeit in einen der q-I Werte des q-teiligen Symbols, außer dem übertragenen Symbol, randomisiert werden.

8. Verfahren nach Anspruch 1 oder 7,
**dadurch gekennzeichnet,**
**dass** die Randomisierung der q-teiligen Symbole nach dem Verfahren ausgeführt wird, das durch eine doppelt-stochastische Übergangsmatrize beschrieben wird und
**dass** ein quasi zufälliger Randomisierungsparameter verwendet wird, welcher von der Quelle unabhängig von der übertragenen Information empfangen wird.

9. Verfahren nach Anspruch 1 oder 7,
**dadurch gekennzeichnet,**
**dass** für die Synchronisierung der Prozesse zur Erzeugung der Randomisierungsparameter in Übertragungs- und Empfangsteilen unveränderte Ausgangswerte des Zustands eines Synchronzufallsgenerators oder eines kryptographischen Systems von geheimen oder öffentlichen Schlüsseln verwendet werden.

10. Verfahren nach Anspruch 1,
**dadurch gekennzeichnet,**
**dass** die Kontrolle der Integrität der empfangenen q-teiligen Symbole des (n, k, q)-Codes mit Hilfe von N = 2^{n-k} -1 Prüfverhältnissen des Codes ausgeführt wird, wobei die Zeilen eine Prüfmatrize eines Binärcodes H und deren Linearkombinationen darstellen,
**dass** die Kontrolle der Integrität für ein j-ges Verhältnis durch Addieren nach dem Modul 2 von n q-teiligen Symbolen ausgeführt wird, wobei das Symbol I in diesem j-gen Prüfverhältnis der Prüfung des Wertes der berechneten Summe entspricht, wobei das Verhältnis als erfüllt gilt und die q-teiligen Symbole vorläufig als vollständig und lokalisiert anerkannt werden, wenn diese Summe der Kombination aus I Nullbinärsymbolen gleich ist und die Anzahl der lokalisierten Symbole N_{I} (N_{I} ⊂ [0, n]) sowie die Anzahl der erfolgten Verhältnisse N_{c} (Nᵥ ⊂ [0,2^{n-k} - I]) berechnet werden und wobei für jedes q-teilige Symbol mit der Nummer i die Anzahl der realisierten Verhältnisse berechnet wird, in dem dieses Symbol Mᵢ enthalten war.

11. Verfahren nach Anspruch 1 oder 10,
**dadurch gekennzeichnet,**
**dass** die Kontrolle der Gültigkeit der Integrität für Codeblöcke durch eine Prüfung der Bedingungen N_{c} = 2^{r-t*} - 1, t* ≤ d - 2 ausgeführt wird, wobei t*= n - N_{I} und d der Codeabstand des binären (n, k)-Codes sind.

12. Verfahren nach Anspruch 1 oder 10,
**dadurch gekennzeichnet,**
**dass** die Kontrolle der Gültigkeit der Integrität der einzelnen q-teiligen Symbole durch eine Prüfung der Bedingungen Mᵢ (*t**) ≥ S_{q}(t*) ausgeführt wird, wobei S_{q}(t*) die Schwellenwerte der Anzahl der ausgeführten Verhältnisse für ein q-teiliges Symbol mit einem bestimmten Wert t* entsprechen und
**dass** Symbole, für welche die Bedingung nicht erfüllt ist, gelöscht werden und der Wert N_{I} um die Anzahl der gelöschten Symbole reduziert wird.

13. Verfahren nach Anspruch 1,
**dadurch gekennzeichnet,**
**dass** die Wiederherstellung der Integrität der Information durch eine Korrektur der nicht lokalisierten und gelöschten Symbole durchgeführt wird, wobei der Wert des korrigierten Symbols durch die Werte der gültigen lokalisierten oder vorher korrigierten Symbole dargestellt wird,
**dass** dafür ein Prüfverhältnis ausgewählt wird, zu welchem ein zu korrigierendes Symbol und andere gültig lokalisierte oder vorher korrigierte Symbole gehören und
**dass** der Wert des korrigierten Symbols durch Addieren nach dem Modul von 2 Werten der gültigen lokalisierten und vorher korrigierten Symbole berechnet wird, die zu dem ausgewählten Prüfverhältnis gehören.

14. Verfahren nach Anspruch 1 oder 10,
**dadurch gekennzeichnet,**
**dass** die Dekodierung der m-Kopien des (n, k, q)-Codes durch eine Lokalisierung und Erfassung der richtig empfangenen Symbole in drei Schritten ausgeführt wird, wobei die Gesamtzahl der erfüllten Verhältnisse und die Anzahl der erfüllten Verhältnisse für jedes Symbol ausgerechnet werden, wobei die m gleichnamigen Symbole wie für den Block des q-teiligen (m, I, q)-Codes paarweise verglichen werden,
**dass** die übereinstimmenden Symbole als lokalisierte Symbole gespeichert werden,
**dass** die richtig empfangenen Symbole für jeden der m-Blöcke nach den Dekodierungsregeln des (n, k, q)-Codes lokalisiert werden,
**dass** die Symbole, die in jedem beliebigen Block lokalisiert wurden, gespeichert werden,
**dass** die vorher nicht lokalisierten Symbole durch eine Substitution der Werte von nicht lokalisierten q-teiligen Symbolen aus unterschiedlichen Kopien in das zu prüfende Prüfverhältnis quer lokalisiert werden,
**dass** die Lokalisierung danach auf Richtigkeit geprüft wird und
**dass** unsichere und nicht lokalisierte Symbole **dadurch** korrigiert werden, dass ihre Werte durch Werte von richtig lokalisierten Symbolen dargestellt werden.

15. Verfahren nach Anspruch 1, **dadurch gekennzeichnet,**
**dass** die Anzahl der Blöcke N_{OT} zur Kontrolle der Optimalität des eingesetzten Codes berechnet wird, bei welchen die Integrität mit einer notwendigen Gültigkeit des Kanals auf einer Länge G der zuletzt empfangenen Blöcke durch den eingesetzten Code nicht wiederhergestellt wurde,
**dass** nach dem Empfang des nächsten Blocks mit nicht wiederhergestellter Integrität der Anteil solcher Blöcke aus α = N_{OT}/ G berechnet wird,
**dass** die Optimalitätsbedingungen für den eingesetzten Code in Form des Verhältnisses βₘᵢₙ ≤ α ≤ βₘₐₓ geprüft werden,
**dass** bei βₘᵢₙ ≥ α eine Entscheidung getroffen wird, ob der eingesetzte Code durch einen störanfälligeren Code ersetzt wird oder wenn α ≥ βₘₐₓ, ob der eingesetzte Code durch einen weniger störanfälligen Code ersetzt wird.

16. Verfahren nach Anspruch 1 oder 2 oder 5,
**dadurch gekennzeichnet,**
**dass** beliebige Duplexkanäle mit einer Übertragungskapazität über Null durch die Kontrolle der Gültigkeit jedes Blocks und durch eine adaptive Auswahl des (n, k, q)-Codes bei m = I verwendet werden, der für den jetzigen Zustand des Kanals optimal ist.

17. Verfahren nach Anspruch 1 oder 2 oder 6,
**dadurch gekennzeichnet,**
**dass** beliebige Simplexkanäle mit einer Übertragungskapazität über Null durch die Kontrolle der Gültigkeit jedes Codeblocks, des q-teiligen Symbols und durch die m-fache Übertragung der Codeblöcke mit einer mitlaufenden Dekodierung der m-Kopien der Codeblöcke verwendet werden, wobei m abhängig von der notwendigen Wahrscheinlichkeit der Lieferung der Nachricht nach der ersten Übertragung durch den eingesetzten Kanal mit Hilfe von ausgewählten (n, k, q)-Codes festgelegt wird und bei der die Übertragung η-fach durch jeden der X parallelen Kanäle (m = Xη) erfolgt.

18. Verfahren nach Anspruch 1 oder 3,
**dadurch gekennzeichnet,**
**dass** der Schutz gegen Verzerrungen in Kanälen und Funknetzen sowie in Informationsspeichern durch eine direkte Wiederherstellung der Integrität mittels eines Codes so ausgeführt wird, dass eine garantierte Gültigkeit in einem beliebigen Kanal bei einer maximal möglichen Geschwindigkeit in Duplexkanälen bestimmter Qualität und eine notwendige Zuverlässigkeit der Lieferung der Nachricht in den Simplexkanälen erreicht werden.

19. Verfahren nach Anspruch 1 oder 3,
**dadurch gekennzeichnet,**
**dass** die Kontrolle der Echtheit und die Wiederherstellung der Informationsintegrität mit Hilfe eines authentifizierten stochastischen q-teiligen (n, k, q, m)-Codes mit Randomisierungseigenschaften erreicht werden, die von der Quelle mit Anfangsausfüllung empfangen und als Authentifizierungsschlüssel verwendet werden.

20. Verfahren nach Anspruch 1 oder 3,
**dadurch gekennzeichnet,**
**dass** die Abgrenzung des Zugangs der Benutzer zur Information durch die Randomisierung der q-teiligen Symbole der Dateien mittels eines Randomisierungsparameters vorgenommen wird, der in den individuellen Schlüsseln der Benutzer erarbeitet wird.

21. Verfahren nach Anspruch 1 oder 3,
**dadurch gekennzeichnet,**
**dass** kryptographischer Schutz gegen Einblick einheitlich unabhängig vom eingesetzten störungssicheren Code durch eine direkte Randomisierung vor der Übergabe in den Kommunikationskanal oder vor dem Speichern der q-teiligen Symbole mit dem Randomisierungsparameter, welcher für jedes q-teiligen Symbol erarbeitet wird, erreicht wird und
**dass** nach dem Empfang aus dem Kommunikationskanal oder nach dem Ablesen vom Speicher für jedes q-teilige Symbol eine Kombination des Randomisierungsparameters mit einer Länge von I erarbeitet wird, das synchron mit der Senderseite jedes q-teiligen Symbols mittels Randomisierungsparameter zurück randomisiert wird.

22. Verfahren nach Anspruch 1 oder 3,
**dadurch gekennzeichnet,**
**dass** der Schutz gegen Aufdrängen falscher Information in einem Kanal mit absichtlichen Störungen mittels eines (n, k, q)-Codes zur Wiederherstellung der Integrität bei einer garantierten Wahrscheinlichkeit des Aufdrängens falscher Information ausgeführt wird, die den Wert q⁻¹ nicht übertrifft.

23. Verfahren nach Anspruch 1 oder 3,
**dadurch gekennzeichnet,**
**dass** der Schutz der Information vor absichtlichen destruktiven Einwirkungen auf das Informationssystem durch die Sicherstellung eines stabilen Informationsaustauschs durch die Adaptation vom Zustand des Kanals ausgeführt wird, wobei eine relative Geschwindigkeit erreicht wird, die sich an die Übertragungskapazität des Kommunikationskanals annähert und
**dass** der Schutz auch bei der Reduzierung der Qualität des Kanals und bei der Codewiederherstellung der Integrität mit dem Schutz gegen Aufdrängen falscher Information sichergestellt wird.

24. Verfahren nach Anspruch 1 oder 2,
**dadurch gekennzeichnet,**
**dass** die garantierten Charakteristika für den Informationsaustausch unter beliebigen Bedingungen der Einwirkungen auf die Informationsverarbeitung durch die Verwendung der Code- und Schlüsselsysteme erreicht werden, die sich für jeden Codeblock und q-teilige Symbole entsprechend ändern und
**dass** alle möglichen 2^{π} Signale auf einer binären Reihenfolge der Länge n in den Kommunikationskanal als ein Ergebnis des Strategiewechsels bei der Bekämpfung der Quelle der destruktiven Einwirkungen auf Information übertragen werden.

25. Verfahren nach Anspruch 1 oder 2,
**dadurch gekennzeichnet,**
**dass** die garantierte zufällig festgelegte Wahrscheinlichkeit eines Dekodierungsfehlers P_{fe} bei der Dekodierung der einzelnen Blöcke (m = 1) und m Kopien im Block des (n, k, q, m)-Codes durch die Korrektur der Fehler bis zu einem bestimmten t-Vielfachen sichergestellt wird, das den Wert t ≤ dm-1 - (log₂ P_{fe})/I nicht übertrifft, wobei bei einem Fehlervielfachen, das diesen Wert übertrifft, die Information an den Benutzer nicht geliefert oder mit einem Kommentar über die Nichterfüllung der Anforderungen zur Gültigkeit geliefert wird.

26. Verfahren nach Anspruch 1 oder 2 oder 10 oder 13,
**dadurch gekennzeichnet,**
**dass** mehrere Gültigkeitsstufen bei einer Basis des q-Codes und dem Codeabstand des d-Binärcodes mittels der Filterung auf der Empfangsseite der dekodierten Blöcke sichergestellt werden, wobei bei einer Anzahl der korrigierten Fehler t = d-2 in diesem Block der Dekodierungsfehler q⁻¹, bei einer Anzahl der korrigierten Fehler t = d-3 der Dekodierungsfehler q⁻² und bei einer Anzahl der korrigierten Fehler t = d-4 der Dekodierungsfehler q⁻³ beträgt.

27. Verfahren nach Anspruch 1 oder 2,
**dadurch gekennzeichnet,**
**dass** eine garantierte Lieferung der Nachricht mit einer geforderten Wahrscheinlichkeit oder ein Austausch in Echtzeit durch die Übertragung der m Blöcke mit dem gleichen Informationsteil und der Wiederherstellung der Integrität im Modus der Dekodierung von Kopien erreicht werden, wobei die Anzahl der Kopien m in Abhängigkeit von der notwendigen Wahrscheinlichkeit der Lieferung der Nachrichten nach der ersten Übertragung Pₗᵢₑ = P(≤ t, N_{nachr}) ermittelt wird, wobei t die Anzahl der korrigierten verzerrten q-teiligen Symbole auf der Länge der Nachricht N_{nachr} darstellt, die mit der Anzahl der q-teiligen Symbole übereinstimmt.
